# EUROPÄISCHE PATENTANMELDUNG

(11) **EP 3 474 451 A1**
(43) Veröffentlichungstag der Anmeldung: **24.04.2019**
(21) Anmeldenummer: 17197305.0
(22) Anmeldetag: 19.10.2017
(51) Int. Cl.: H03K 17/95, A24C 5/34, G01N 27/90, G01V 3/10, G07D 7/04

(54) **SENSORVORRICHTUNG, DETEKTIONSVERFAHREN FÜR EINE SENSORVORRICHTUNG UND VERWENDUNG EINER SENSORVORRICHTUNG**

(71) Anmelder: Imst Gmbh, 47475 Kamp-Lintfort (DE)
(72) Erfinder: BÖTTCHER, Martin, 47441 Moers (DE)
(74) Vertreter: Zimmermann & Partner Patentanwälte mbB

(57) **Zusammenfassung**

Eine Sensorvorrichtung zum Detektieren eines Gegenstandes (1) mit einem Fremdstoffanteil weist eine Oszillatorschaltung (10) mit einem Sensorelement (L), das einen Detektionsbereich (15) für den Gegenstand (1) mit dem Fremdstoffanteil definiert, wobei die Oszillatorschaltung einen einzigen Schwingkreis aufweist, eine Betriebsgrößen-Ermittlungseinrichtung (20), die dazu konfiguriert ist, eine Betriebsgröße zu ermitteln, die mit einer Stromaufnahme der Oszillatorschaltung (10) während eines Sensorbetriebs der Oszillatorschaltung (10) zusammenhängt, und eine Auswertungseinrichtung (40) auf, die dazu konfiguriert ist, unter Verwendung der mit der Betriebsgrößen-Ermittlungseinrichtung (20) ermittelten Betriebsgröße auszuwerten, ob der Gegenstand (1) mit dem Fremdstoffanteil in dem Detektionsbereich (15) vorhanden ist. Verfahren und Verwendung der Sensorvorrichtung.

## Beschreibung

### TECHNISCHES GEBIET

Die Offenbarung betrifft eine Sensorvorrichtung zum Detektieren eines Gegenstandes, der einen Fremdstoffanteil hat. Ferner betrifft die Offenbarung ein Verfahren zum Detektieren des Vorhandenseins eines Gegenstandes, der einen Fremdstoffanteil hat, mittels einer Sensorvorrichtung. Weiterhin betrifft die Offenbarung die Verwendung einer Sensorvorrichtung zum Detektieren eines Gegenstandes, der einen Fremdstoffanteil hat, an einer Verarbeitungs- oder Verpackungsstrecke für Lebensmittel, oder an einer Verarbeitungs- oder Verpackungsstrecke für Tabakteilprodukte und/oder Tabakprodukte.

### STAND DER TECHNIK

In vielen technischen Bereichen müssen Gegenstände, die einen Fremdstoffanteil haben, zur Prozesssteuerung oder aus Sicherheitsgründen detektiert werden.

Detektieren umfasst beispielsweise einen Erkennungsvorgang, ob zu einem bestimmten Zeitpunkt ein Gegenstand mit einem Fremdstoffanteil, beispielsweise einem metallischen Anteil, in einem bestimmten räumlichen Gebiet (einem Detektionsbereich) vorhanden ist. Teilweise ist es auch wünschenswert, die Geschwindigkeit oder die Position eines Fremdstoffanteils in einem Gegenstand zu bestimmen.

Ein Beispiel für eine Prozesssteuerung, bei welcher die Lage und/oder die Geschwindigkeit eines Fremdstoffanteils in einem Gegenstand zuverlässig detektiert werden muss, ist das technische Gebiet der Tabakproduktverarbeitung. Beispielsweise wird in einer Maschine zur Zigarettenherstellung ein ungeschnittener Strang (eine "Endloszigarette") mit hoher Geschwindigkeit durch eine Verarbeitungsmaschine geführt. Einzelne Bereiche des Zigarettenstrangs enthalten eine metallische Markierung, beispielsweise ein Plättchen aus einem magnetisch verlustbehafteten Material. Trotz der hohen Verarbeitungs- bzw. Fertigungsgeschwindigkeit, mit welcher der Strang durch die Maschine geführt wird, ist eine zuverlässige und sichere Detektion der metallischen Markierungen (des metallischen Anteils) in dem Strang wünschenswert, d. h. insbesondere eine Bestimmung der Position und/oder der Ausrichtung (Lage) und/oder der Geschwindigkeit und/oder der Größe der einzelnen metallischen Anteile oder Markierungen.

Das Dokument WO 01/08309 A2 beschreibt eine elektronische Schaltung zum Detektieren einer Veränderung relativ zu einem bewegungslosen Zustand. Fig. 2 der WO 01/08309 A2 zeigt eine Oszillatorschaltung, die zwei npn-Transistoren mit jeweils einem Einzelschwingkreis aufweisen. Eine Asymmetrie durch eine Veränderung des Gütefaktors (Q-Faktors) zwischen den beiden Einzelschwingkreisen bewirkt eine Spannungsdifferenz zwischen den Ausgängen der elektronischen Schaltung. Eine der Schwingkreisspulen der jeweiligen Einzelschwingkreise bildet eine veränderliche Impedanz, deren Größe durch einen externen Einfluss veränderbar ist.

Die aus der WO 01/08309 A2 bekannte Schaltung benötigt zur Auswertung der Spannungsdifferenz an den jeweiligen Ausgängen der beiden Einzelschwingkreise der Oszillatorschaltung ein zusätzliches nichtlineares Bauelement, beispielsweise eine Diode, und eine zusätzliche Auswertungsschaltung zum Auswerten einer spannungsbezogenen Größe an dem nichtlinearen Bauelement. Die beiden Einzelschwingkreise der Oszillatorschaltung führen zu einem komplexen Aufbau, zu einer verringerten Detektionsempfindlichkeit und zu einer verringerten Detektionsgeschwindigkeit der Schaltung.

Es ist daher wünschenswert, eine Möglichkeit zum Detektieren eines Gegenstandes mit einem Fremdstoffanteil zu schaffen, bei welcher die Detektion vereinfacht ist oder bei welcher die Detektionsempfindlichkeit oder die Detektionsgeschwindigkeit verbessert sind.

### ZUSAMMENFASSUNG DER OFFENBARUNG

Die hierin beschriebene Lösung sieht eine Sensorvorrichtung zum Detektieren eines Gegenstandes mit einem Fremdstoffanteil vor, die umfasst:
Eine Oszillatorschaltung mit einem Sensorelement, das einen Detektionsbereich für den Gegenstand mit dem Fremdstoffanteil definiert, wobei die Oszillatorschaltung einen einzigen Schwingkreis aufweist; eine Betriebsgrößen-Ermittlungseinrichtung, die dazu konfiguriert ist, eine Betriebsgröße zu ermitteln, die mit einer Stromaufnahme der Oszillatorschaltung während eines Sensorbetriebs der Oszillatorschaltung zusammenhängt; und eine Auswertungseinrichtung, die dazu konfiguriert ist, unter Verwendung der mit der Betriebsgrößen-Ermittlungseinrichtung ermittelten Betriebsgröße auszuwerten, ob der Gegenstand mit dem Fremdstoffanteil in dem Detektionsbereich vorhanden ist.

Des Weiteren weist ein hierin beschriebenes Verfahren zum Detektieren des Vorhandenseins eines Gegenstandes mit einem Fremdstoffanteil mittels einer hierin beschriebenen Sensorvorrichtung Folgendes auf:
Bereitstellen eines Detektionsbereichs für einen Gegenstand mit einem Fremdstoffanteil; Betreiben der Oszillatorschaltung der Sensorvorrichtung in einem Sensorbetrieb; Ermitteln einer Betriebsgröße, die mit einer Stromaufnahme der Oszillatorschaltung während des Sensorbetriebs zusammenhängt; und Vergleichen der ermittelten Betriebsgröße mit einem Referenzwert für die Betriebsgröße, und Auswerten, anhand des Vergleichsergebnisses, ob ein Gegenstand mit einem Fremdstoffanteil im Detektionsbereich vorhanden ist.

Ein weiteres hierin beschriebenes Verfahren zum Detektieren der Bewegung eines Gegenstandes mit einem Fremdstoffanteil mittels einer hierin beschriebenen Sensorvorrichtung weist Folgendes auf:
Bereitstellen eines Detektionsbereichs für einen sich relativ zum Sensorelement der Oszillatorschaltung bewegenden Gegenstand mit einem Fremdstoffanteil; Betreiben der Oszillatorschaltung der Sensorvorrichtung in einem Sensorbetrieb; Ermitteln einer Betriebsgröße, die eine Wertveränderung einer zeitlichen Folge von Messwerten einer Stromaufnahme der Oszillatorschaltung in einem Detektionszeitraum während des Sensorbetriebs ist; und Vergleichen der ermittelten Betriebsgröße mit einem Referenzwert für die Betriebsgröße, und Auswerten, anhand des Vergleichsergebnisses, ob sich im Detektionszeitraum ein Gegenstand mit einem Fremdstoffanteil im Detektionsbereich bewegt hat.

Ein Gegenstand mit Fremdstoffanteil, wie hierin verwendet, beschreibt insbesondere einen Gegenstand, der bereichsweise (in einem räumlichen Gebiet oder in mehreren räumlichen Gebieten des Gegenstandes) einen Fremdstoff aufweist, der ein Material aus einer Gruppe umfasst, die aus Metall, Graphit oder Ferrit besteht. Beispielsweise bezeichnet ein Fremdstoffanteil einen metallischen Anteil wie eine räumlich begrenzte metallische Markierung. Ein solcher Fremdstoffanteil wird typischerweise dann angenommen, wenn er in Abschnitten oder Bereichen des Gegenstandes detektiert werden soll, der Gegenstand allerdings während eines überwiegenden Zeitraums des Detektionsbetriebs im Detektionsbereich vorhanden ist.

Mit anderen Worten: Beispiele für einen Fremdstoffanteil sind ein metallischer Anteil, ein Graphitanteil oder ein Ferritanteil, die typischerweise bereichsweise in einem Gegenstand vorhanden sein können. Ein weiteres Beispiel für einen Fremdstoffanteil ist ein bereichsweise in dem Gegenstand vorhandenes dielektrisch verlustbehaftetes Material.

Ein Gegenstand mit Fremdstoffanteil, wie hierin verwendet, kann auch ein Gegenstand sein, der gänzlich oder überwiegend aus Metall, Graphit oder Ferrit bzw. aus einem dielektrisch verlustbehafteten Material ist, wie beispielsweise ein Metallsplitter. Ein solcher Fremdstoffanteil wird typischerweise dann angenommen, wenn in den Detektionsbereich normalerweise Gegenstände eintreten, die keinen solchen Fremdstoffanteil haben, und sporadisch Gegenstände eintreten, die einen solchen Fremdstoffanteil haben.

Typischerweise ist der Fremdstoffanteil ein magnetisch verlustbehaftetes Material, das beim Einbringen in den Detektionsbereich eine Auswirkung auf die Resonanzbedingung des Schwingkreises der Oszillatorschaltung hat. Als ein magnetisch verlustbehaftetes Material wird insbesondere ein Material angenommen, dessen relative magnetische Permeabilität µᵣ einen Wert hat, der deutlich größer als 1 ist, beispielsweise größer als 100 oder größer als 1000.

Die hierin beschriebene Sensorvorrichtung ist sehr empfindlich. Es reicht schon ein räumlich relativ kleiner Fremdstoffanteil aus, um eine relativ große Veränderung der Betriebsgröße messbar zu machen, die mit der Stromaufhahme zusammenhängt. Nicht-einschränkende Beispiel für Gegenstände mit einem Fremdstoffanteil, der ein metallischer Anteil ist, sind Drähte, Folien, Späne, Körner aus Eisen oder Nickel in einem dielektrischen Material, beispielsweise enthalten in einem Materialmix aus Gegenständen ohne einen metallischen Anteil und sporadischen Gegenständen mit einem metallischen Anteil, wobei der Materialmix mit hoher Geschwindigkeit durch den Detektionsbereich geführt wird.

Typischerweise schwingt die Oszillatorschaltung auf einer Betriebsfrequenz in einem Frequenzbereich zwischen 100 kHz und 100 MHz.

In der vorliegenden Offenbarung wird eine Betriebsgröße ermittelt, die mit der Stromaufhahme der Oszillatorschaltung während des Sensorbetriebs der Oszillatorschaltung zusammenhängt. Die Oszillatorschaltung weist einen einzigen Schwingkreis auf. Dementsprechend kann mit einem sehr einfachen Aufbau ein Fremdstoffanteil, beispielsweise eine metallische Markierung, in einem Gegenstand sicher und mit hoher Empfindlichkeit detektiert werden, wenn sich der Gegenstand im Detektionsbereich befindet und/oder entlang des Detektionsbereiches bzw. durch den Detektionsbereich hindurch bewegt wird.

Es kann auf einen zweiten Schwingkreis in der Oszillatorschaltung verzichtet werden, was die Schaltung vereinfacht. Die Stromaufnahme kann auf einfache Weise detektiert werden, beispielsweise als Spannungsabfall über einem entsprechenden Messwiderstand. Es ist keine aufwändige und schaltungstechnisch kompliziertere Differenzmessung erforderlich, um die Betriebsgröße zu ermitteln.

Der unbelastete Schwingkreis der Oszillatorschaltung weist eine hohe Leerlaufgüte auf. Eine Leerlaufgüte wird beispielsweise beschrieben durch den Gütefaktor (Q-Faktor) der Oszillatorschaltung, ohne dass ein magnetisch verlustbehaftetes Material bzw. ohne dass ein dielektrisch verlustbehaftetes Material in den Detektionsbereich eingebracht ist. Beispielsweise hat die Oszillatorschaltung einen Leerlauf-Gütefaktor von mindestens Q=70 oder von mindestens Q=80.

Mit der hierin beschriebenen Sensorvorrichtung ist es beispielsweise möglich, ohne eine weitere Signalverstärkung des Ausgabesignals aus der Oszillatorschaltung die Betriebsgröße zu ermitteln und auszuwerten. Beispielsweise ergeben sich bei typischen Detektionsvorgängen Unterschiede der Betriebsgröße, beispielsweise der unmittelbaren Stromaufhahme der Oszillatorschaltung, von einem Faktor 5 oder mehr, beispielsweise auch von einem Faktor 10, wenn ein Gegenstand mit einem Fremdstoffanteil in den Detektionsbereich eingebracht wird, typischerweise ein Gegenstand mit einem Anteil aus magnetisch verlustbehaftetem Material.

Gemäß einer Verwendung ist es vorgesehen, eine hierin beschriebene Sensorvorrichtung oder ein hierin beschriebenes Verfahren, das eine hierin beschriebene Sensorvorrichtung verwendet, zur Detektion eines Gegenstands mit einem Fremdstoffanteil, insbesondere einem metallischen Anteil, an einer Verarbeitungs- oder Verpackungsstrecke für Lebensmittel zu verwenden.

Ein Beispiel für einen Gegenstand mit einem metallischen Anteil ist ein Metallsplitter. Bei der beschriebenen Verwendung muss ein solcher Metallsplitter sicher detektiert werden, um ausschließen zu können, dass das zu verarbeitende bzw. zu verpackende Lebensmittel mit Metallsplittern verunreinigt ist. Die beschriebene Verwendung kann durch die hohe Detektionsempfindlichkeit (Größe, Lage und/oder Geschwindigkeit) eine solche zuverlässige Detektion erreichen.

Gemäß einer weiteren Verwendung ist es vorgesehen, eine hierin beschriebene Sensorvorrichtung oder ein hierin beschriebenes Verfahren, das eine hierin beschriebene Sensorvorrichtung verwendet, zur Detektion eines Gegenstands mit einem Fremdstoffanteil, insbesondere einem metallischen Anteil, an einer Verarbeitungs- oder Verpackungsstrecke für Tabakteilprodukte und/oder Tabakprodukte, optional für Zigaretten-Teilprodukte oder Zigarettenprodukte zu verwenden.

Ein Zigaretten-Teilprodukt ist beispielsweise ein ungeschnittener Strang einer EndlosZigarette, wie eingangs beschrieben. Mit der hierin beschriebenen Verwendung ist es auf einfache Weise möglich, beispielsweise ein Markierungsplättchen im Strang in Größe, Lage und/oder Geschwindigkeit einfach und sicher zu detektieren.

Bei Ausführungsformen weist die Auswertungseinrichtung eine Vergleichseinrichtung auf, die dazu konfiguriert ist, die mit der Betriebsgrößen-Ermittlungseinrichtung detektierte Betriebsgröße mit einem Referenzwert für die Betriebsgröße zu vergleichen.

Im einfachsten Fall ist die Betriebsgröße die tatsächliche Stromaufnahme der Oszillatorschaltung, und der Referenzwert für die Betriebsgröße ist ein Wert nahe null. In einem Sensorbetrieb befindet sich die Oszillatorschaltung typischerweise in einem eingeschwungenen Zustand. Die Oszillatorschaltung arbeitet dann im nichtlinearen Bereich, deren Ausgangsspannung ist begrenzt, und sie schwingt mit weitgehend konstanter Amplitude in einem stabilen Arbeitspunkt. Da kaum Verluste herrschen, benötigt die Oszillatorschaltung auch nur einen kleinen Strom als Betriebsgröße, beispielsweise und ohne Einschränkung ungefähr 50 mA. Ein so vorab ermittelter Wert kann als Referenzwert für die Betriebsgröße verwendet werden.

Bei einer Veränderung der Schwingungsbedingung, vorliegend durch ein Einbringen eines Gegenstandes mit einem Fremdstoffanteil in den Detektionsbereich, ändern sich die Verluste im Schwingkreis der Oszillatorschaltung. Die Schwingungsamplitude sinkt, die Oszillatorschaltung verharrt jedoch in dem beschriebenen stabilen Arbeitspunkt. Infolge einer hohen Kreisverstärkung werden die zunehmenden Verluste im Oszillator ausgeglichen, und die Ausgangsspannung steigt wiederum auf ungefähr den gleichen Wert an, der vor der Veränderung der Schwingungsbedingung vorherrschte.

Um die Verluste auszugleichen, steigt der Betriebsstrom der Oszillatorschaltung an, d. h. die Stromaufhahme erhöht sich. Beispielsweise und ohne Einschränkung erhöht sich die Stromaufhahme als die Betriebsgröße der Oszillatorschaltung auf einen Wert von 250 mA.

Bei Ausführungsformen ist die Betriebsgröße eine Wertveränderung der Stromaufhahme in einer zeitlichen Folge von Messwerten der Stromaufnahme der Oszillatorschaltung. Gemäß einem weiteren Aspekt ist die Auswertungseinrichtung dazu konfiguriert, die Betriebsgröße fortlaufend in einem zeitlichen Abstand von weniger als 5 µs, optional weniger als 2 µs oder weniger als 1 µs auszuwerten.

Beispielsweise werden in zeitlicher Folge, typischerweise durch zeit- und wertdiskrete Abtastung, Messwerte der Stromaufhahme der Oszillatorschaltung erfasst. Eine solche Erfassung kann fortlaufend und zeitlich unbegrenzt während des gesamten Sensorbetriebs der Oszillatorschaltung erfolgen. Eine Wertveränderung der Stromaufnahme ist typischerweise eine Veränderung der Amplitude der abgetasteten Werte über einen bestimmten Zeitraum, z. B. während eines Zeitraums von 5 µs oder von 2 µs oder von 1 µs. Beispielsweise ändert sich die Amplitude innerhalb des Zeitraums auf das Zweifache, auf das Fünffache oder auf das Zehnfache, oder jegliche Werte dazwischen.

Anhand einer Anstiegszeit und/oder einer Abfallzeit der Messwerte kann bei auf eine Bewegungsgeschwindigkeit des Gegenstandes durch den Detektionsbereich geschlossen werden. Außerdem ist es möglich, durch eine Auswertung von Anstiegszeit, Abfallzeit und/oder Amplitude eine Größe und/oder Lage eines Fremdstoffanteils in dem bewegten Gegenstand zu erfassen.

Bei Ausführungsformen ist die Oszillatorschaltung als Push-pull-Oszillator ausgebildet. Die Oszillatorschaltung kann zwei in Reihe geschaltete Transistoren aufweisen. Ein Push-pull-Oszillator als Form eines symmetrischen Oszillator, insbesondere mit zwei in Reihe geschalteten Transistoren, weist die Oszillatorschaltung eine besonders hohe Kreisverstärkung auf. Hierdurch kann sichergestellt werden, dass die Oszillatorschaltung auch dann sicher schwingt (die Resonanzbedingung erfüllt ist), wenn im Schwingkreis größere Verluste auftreten. Beim Einbringen eines verlustbehafteten Materials, beispielsweise eines Gegenstandes mit einem magnetisch verlustbehafteten Metallteil oder eines Gegenstandes mit einem dielektrisch verlustbehafteten Materialteil, in den Detektionsbereich werden die Verluste im Schwingkreis stark erhöht. Die hohe Kreisverstärkung kann dazu beitragen, dass auch bei solchen größeren Verlusten die Detektion sicher möglich ist. Zudem kann die Detektionsempfindlichkeit und/oder die Detektionsgeschwindigkeit verbessert werden.

Bei Ausführungsformen ist das Sensorelement eine Spule oder eine Reihenschaltung von Spulen. Bei einem als Spule oder als eine Reihenschaltung von Spulen ausgebildeten Sensorelement weist ein detektierbarer Fremdstoffanteil ein magnetisch verlustbehaftetes Material auf, beispielsweise ein Metall, Ferrit oder Graphit. Typischerweise ist die Spule oder die Reihenschaltung von Spulen eine Luftspule, und vorzugsweise ist der Detektionsbereich innerhalb des Luftraumes der Luftspule bereitgestellt. Mit anderen Worten: Zur Detektion eines magnetisch verlustbehafteten Materialanteils, beispielsweise Metallanteils, an einem Gegenstand wird der Gegenstand durch den Luftraum der Spule geführt. Wenn der Materialanteil eintritt, typischerweise ein magnetisch verlustbehaftetes Metallteil in dem Gegenstand, ändern sich die Verluste des Schwingkreises, so dass die Stromaufhahme der Oszillatorschaltung steigt.

Bei Ausführungsformen ist das Sensorelement ein Plattenkondensator. Bei einem als Plattenkondensator ausgebildeten Sensorelement weist ein detektierbarer Fremdstoffanteil ein dielektrisch verlustbehaftetes Material auf, beispielsweise einen Kunststoff. Typischerweise ist der Detektionsbereich zwischen den Kondensatorplatten bereitgestellt. Zur Detektion eines dielektrisch verlustbehafteten Materialanteils wird der Gegenstand durch den Luftraum zwischen den Kondensatorplatten geführt. Wenn der Materialanteil eintritt, ändern sich die Verluste des Schwingkreises, so dass die Stromaufnahme der Oszillatorschaltung steigt.

Bei einem vergleichsweise langsamen Einführen des Gegenstandes kann anhand der Stromaufhahme auf ein Vorhandensein oder Nichtvorhandensein des Fremdstoffanteils des Gegenstandes im Detektionsbereich geschlossen werden. Bei einem relativ schnellen Einführen oder Durchführen des Gegenstandes kann anhand einer Veränderung von Messwerten für die Stromaufhahme auf eine Bewegung des Fremdstoffanteils des Gegenstandes im Detektionsbereich bzw. durch den Detektionsbereich hindurch geschlossen werden. Mit der Bewegung zusammenhängende Größen wie beispielsweise die Geschwindigkeit oder, bei bekannter Geschwindigkeit, von Position und/oder Lage des Fremdstoffanteils im Gegenstand können ebenfalls ermittelt werden.

### KURZE BESCHREIBUNG DER ZEICHNUNGEN

Nachfolgend werden Ausführungsformen anhand von Zeichnungen näher erläutert. Die Ausführungsformen sind anschaulich und nicht einschränkend zu verstehen, und die Ausführungsformen können frei kombiniert werden, und einzelne Elemente können weggelassen werden, wenn angemessen. In den Zeichnungen zeigen:
- Fig. 1: ein Schaltungsdiagramm eines Teils einer Sensorvorrichtung gemäß einer Ausführungsform der Offenbarung;
- Fig. 2: ein Oszillogramm einer Demonstrationsschaltung zum Veranschaulichen der Wirkungsweise der Sensorvorrichtung;
- Fig. 3: ein schematisches Blockschaltbild einer Sensorvorrichtung gemäß einer Ausführungsform der Offenbarung;
- Fig. 4: ein Ablaufdiagramm eines Verfahrens, das eine hierin beschriebene Sensorvorrichtung verwendet, gemäß einer Ausführungsform der Offenbarung; und
- Fig. 5: ein Ablaufdiagramm eines weiteren Verfahrens, das eine hierin beschriebene Sensorvorrichtung verwendet, gemäß einer Ausführungsform der Offenbarung.

### BESCHREIBUNG VON AUSFÜHRUNGSFORMEN

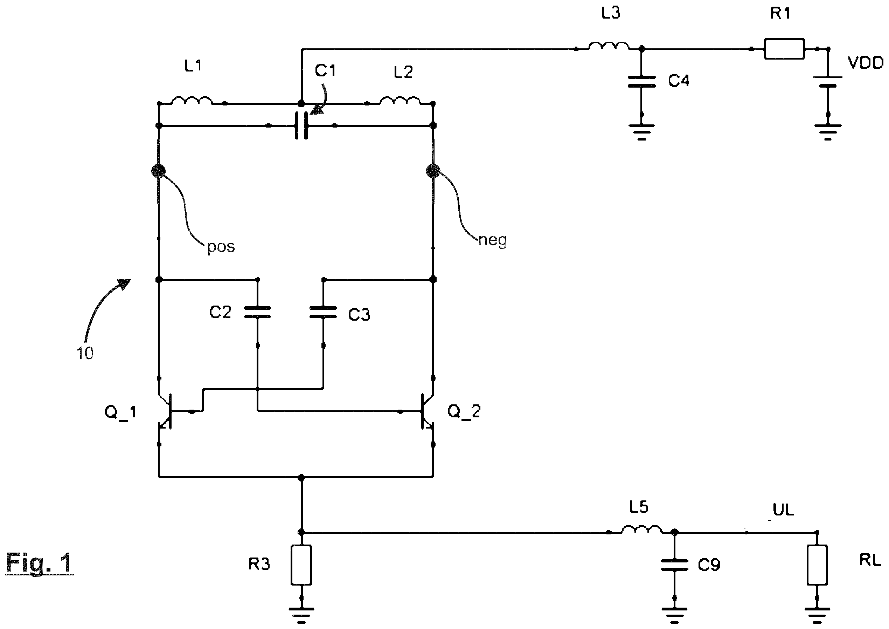

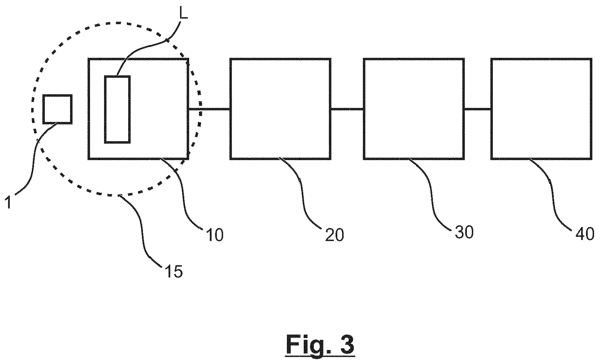

Fig. 1 zeigt ein Schaltungsdiagramm eines Teils einer Sensorvorrichtung gemäß einer Ausführungsform der Offenbarung. In der linken Hälfte von Fig. 1 ist eine Oszillatorschaltung 10 der Sensorvorrichtung gezeigt. Ein Sensorelement aus einer Reihenschaltung von zwei Luftspulen L1, L2 wirkt in einem Einzelschwingkreis aus den Induktivitäten L1, L2 und dem Kondensator C1 mit letzterem zusammen. Die Resonanzfrequenz des Schwingkreises L1, L2, C1 beträgt beispielsweise ca. 1 MHz, ist darauf jedoch nicht beschränkt. Beispielsweise ist die Resonanzfrequenz des Schwingkreises L1, L2, C1 in einem Bereich zwischen 100 kHz und 100 MHz. Das Sensorelement stellt im Inneren der Luftspulen L1, L2 einen Detektionsbereich 15 für einen Gegenstand mit einem magnetisch verlustbehafteten Fremdstoffanteil bereit, wie später noch unter Bezug auf Fig. 3 beschrieben.

Der Detektionsbereich 15 ist jedoch nicht auf das Innere der Luftspulen L1, L2 beschränkt. Beispielsweise können auch andere Bauformen von Spulen verwendet werden, und der Detektionsbereich 15 ist in einem Bereich der Spulen bereitgestellt, in welchem ein ausreichend messbarer Einfluss des magnetisch verlustbehafteten Fremdstoffanteils auf die Schwingkreischarakteristik gegeben ist.

Ähnlich kann ein Detektionsbereich 15 für einen Gegenstand mit einem dielektrisch verlustbehafteten Anteil auch durch kapazitiv wirkende Elemente, beispielsweise einen (nicht dargestellten) Plattenkondensator gebildet werden. Der Detektionsbereich 15 ist dann beispielsweise zwischen den Platten eines solchen Plattenkondensators bereitgestellt, oder in einem Bereich des Plattenkondensators, in welchem ein ausreichend messbarer Einfluss des dielektrisch verlustbehafteten Fremdstoffanteils auf die Schwingkreischarakteristik gegeben ist.

Zwei Transistoren Q_1, Q_2 sind als npn-Bipolartransistoren gezeigt, darauf jedoch nicht beschränkt. Die Transistoren Q_1, Q_2 sind symmetrisch in Push-pull-Konfiguration verschaltet und tragen über die Rückkopplungstransistoren C2, C3 zu einer verstärkten Oszillation im eingeschwungenen Zustand bei. Trennt man die Schaltung an einer Stelle auf, wie bei Oszillatoren zur Analyse üblich, erkannt man die Reihenschaltung der zwei Transistoren. Durch die Reihenschaltung aus Q_1 und Q_2 hat die Oszillatorschaltung 10 eine besonders hohe Kreisverstärkung.

Nach dem Einschalten der Betriebsspannung VDD für die Oszillatorschaltung 10 wächst die Schwingungsamplitude solange an, bis die Oszillatorschaltung 10 in den nichtlinearen Bereich kommt und dadurch in der Ausgangsspannung begrenzt wird. Danach schwingt die Oszillatorschaltung 10 mit im Wesentlichen konstanter Amplitude weiter. Es entsteht eine sinusförmige Ausgangsspannung zwischen zwei fiktiven Messpunkten pos und neg. Der Oszillator stabilisiert sich auf diesem Arbeitspunkt.

Ändern sich die Verluste im Schwingkreis, so würde die Schwingungsamplitude zurückgehen. Eine Verlustveränderung wird beispielsweise dadurch bewirkt, dass ein Gegenstand mit einem magnetisch verlustbehafteten Material, typischerweise ein Gegenstand mit einem metallischen Anteil, in den durch die Spulen L1, L2 bereitgestellten Detektionsbereich 15 eingebracht wird. Beispielsweise wird ein Gegenstand mit einem Abschnitt, der ein ferromagnetisches Material aufweist, durch den Detektionsbereich 15 bewegt, so dass sich die Verluste im Schwingkreis ändern. Vergleichbares gilt für den Fall, dass ein Gegenstand mit einem dielektrisch verlustbehafteten Material in einen im Bereich der Platten oder zwischen den Platten eines Plattenkondensators bereitgestellten Detektionsbereich 15 eingebracht wird. Beispielsweise ist der Schwingkreiskondensator C1 als ein solcher Plattenkondensator ausgebildet.

Der Oszillator regelt diese Änderung der Schwingungsamplitude aus, indem die Stromaufhahme erhöht wird, was sich messbar an der Betriebsstromaufnahme zeigt. Die Größe der Änderung der Stromaufhahme hängt von der Grundgüte des unbelasteten Schwingkreises L1, L2, C1 ab, sowie von der Größe der Probe und der Beschaffenheit der Probe, beispielsweise dem Wert der relativen magnetischen Permeabilität der Probe.

Der Spannungsabfall über einem Messwiderstand R3 ist ein Maß für den Betriebsstrom der Oszillatorschaltung 10. Ein Tiefpassfilter aus einer Induktivität L5 und einem Kondensator C9 stellt eine Ausgangsspannung UL an einem Lastwiderstand RL bereit. Die Ausgangsspannung UL ist ein messbares Maß für den Betriebsstrom der Oszillatorschaltung 10, der eine Betriebsgröße ist, die mit der Stromaufhahme der Oszillatorschaltung 10 zusammenhängt.

Die Sensorvorrichtung mit der Oszillatorschaltung 10 kann eine sehr schnelle Anstiegszeit messen, da der Schwingkreis stark gedämpft ist und keine weiteren Auswertungen oder Berechnungen nötig sind, außer die Stromaufhahme über die Ausgangsspannung UL auszuwerten. Die Abfallszeit der Sensorvorrichtung kann langsamer sein als die Anstiegszeit, beispielsweise 5- bis 10-mal so langsam wie die Anstiegszeit, da der Schwingkreis eine hohe Güte aufweist. Ein typischer, nicht-einschränkender Wert für die Anstiegszeit und für die Abfallszeit ist ca. 1 µs.

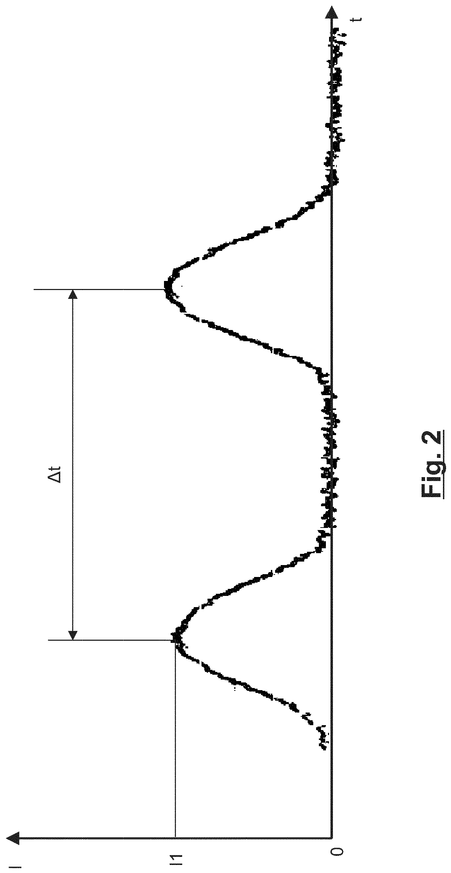

Fig. 2 zeigt ein Oszillogramm einer Demonstrationsschaltung zum Veranschaulichen der Wirkungsweise der Sensorvorrichtung, die die Oszillatorschaltung 10 aus Fig. 1 aufweist. In einem Experiment mit der Demonstrationsschaltung wurden zwei Probekörper aus Nickelfolie in einem Kunststoffzylinder, die in einem Abstand von 55 mm zueinander angeordnet waren, mit einer Geschwindigkeit von 22,5 m/s durch die Luftspulen L1, L2 bewegt. Die Probekörper waren kürzer als die Luftspulen L1, L2. Die Scheitelwerte der beiden Impulse, deren Wert jeweils ungefähr I1=100 mV/RL betrug, sind deutlich erkennbar und damit gut messbar. Der zeitliche Abstand Δt zwischen den beiden Impulsen betrug ca. 2,44 ms. Eine deutlich schnellere Bewegungsgeschwindigkeit würde ebenfalls gut messbare Peaks erzeugen. Längere Probenkörper wären als Plateaus zu erkennen.

Fig. 3 zeigt ein schematisches Blockschaltbild einer Sensorvorrichtung gemäß einer Ausführungsform der Offenbarung. Die Oszillatorschaltung 10 weist ein Sensorelement L auf, das beispielsweise eine Reihenschaltung aus zwei Luftspulen L1, L2 ist. Das Sensorelement L definiert den Detektionsbereich 15, beispielsweise innerhalb des Luftraums der Luftspulen L1, L2. Ein Gegenstand 1 ist in Fig. 3 im Detektionsbereich 15 befindlich dargestellt. Die Oszillatorschaltung 10 ist beispielsweise so aufgebaut, wie unter Bezugnahme auf Fig. 1 beschrieben. Es ist auch möglich, wie hierin beschrieben, dass das Sensorelement L ein Element ist, das dazu konfiguriert ist, dielektrische Verluste zu messen, beispielsweise ein Plattenkondensator oder dergleichen.

Mit einem Ausgang der Oszillatorschaltung 10 ist eine Betriebsgrößen-Ermittlungseinrichtung 20 verbunden, die eine Betriebsgröße ermittelt, die mit einer Stromaufhahme der Oszillatorschaltung 10 während eines Sensorbetriebs der Oszillatorschaltung 10 zusammenhängt. Beispielsweise tastet die Betriebsgrößen-Ermittlungseinrichtung 20 Spannungsmesswerte am Lastwiderstand RL aus Fig. 1 fortlaufend ab und gibt die abgetasteten Werte mittelbar oder unmittelbar an eine Auswertungseinrichtung 40 aus.

Die Auswertungseinrichtung 40 ist dazu konfiguriert, unter Verwendung der Betriebsgröße, die von der Betriebsgrößen-Ermittlungseinrichtung 20 ermittelt wurde, auszuwerten, ob der Gegenstand 1 in dem im Detektionsbereich 15 befindlichen Teil einen Fremdstoffanteil aufweist, also ob ein Gegenstand 1, der einen Fremdstoffanteil aufweist, in dem Detektionsbereich 15 vorhanden ist. Ein solches Auswerten kann beispielsweise beinhalten, dass ein Scheitelwert der Betriebsgröße einen Schwellenwert überschreitet, oder dergleichen.

In Fig. 3 ist zwischen die Auswertungseinrichtung 40 und die Betriebsgrößen-Ermittlungseinrichtung 20 eine Vergleichseinrichtung 30 geschaltet. Die Vergleichseinrichtung 30 vergleicht einen Referenzwert für die Betriebsgröße mit der detektierten Betriebsgröße. Der Referenzwert ist beispielsweise ein vorab ermittelter Wert für einen Leerlaufbetrieb der Oszillatorschaltung 10, in welchem die Oszillatorschaltung unbelastet ist und keine nennenswerten Verluste im Sensorelement L auftreten.

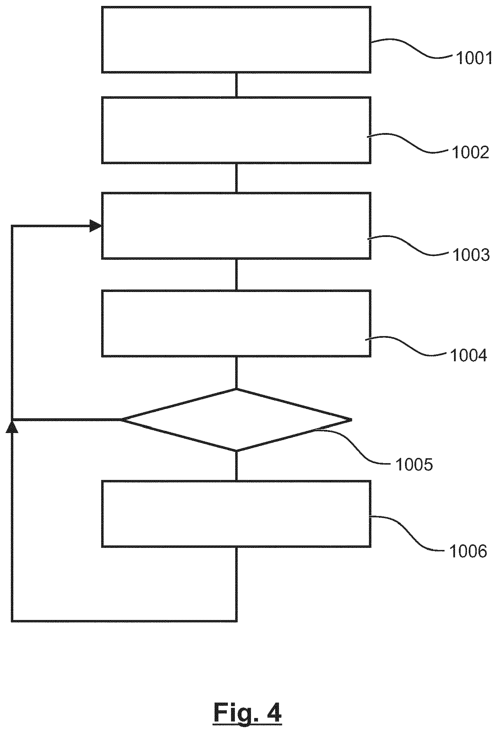

Fig. 4 zeigt ein Ablaufdiagramm eines Verfahrens, das eine hierin beschriebene Sensorvorrichtung verwendet, gemäß einer Ausführungsform der Offenbarung.

In 1001 wird zunächst ein Detektionsbereich 15 für einen Gegenstand 1 mit einem Fremdstoffanteil, beispielsweise einem metallischen Anteil, bereitgestellt. In 1002 wird die Oszillatorschaltung 10 der Sensorvorrichtung in einen Sensorbetrieb versetzt, beispielsweise, indem die Versorgungsspannung VDD eingeschaltet wird.

In 1003 wird dann eine Betriebsgröße ermittelt, die mit einer Stromaufnahme der Oszillatorschaltung 10 zusammenhängt, beispielsweise ein Betriebsstrom über dem Lastwiderstand RL.

In 1004 wird die ermittelte Betriebsgröße mit einem Referenzwert für die Betriebsgröße verglichen.

In 1005 wird anhand des Vergleichsergebnisses ausgewertet, ob ein Gegenstand 1 mit einem Fremdstoffanteil im Detektionsbereich 15 vorhanden ist. Wenn ein Gegenstand mit einem Fremdstoffanteil vorhanden ist, fährt das Verfahren mit 1006 fort. In 1006 wird ausgegeben, dass ein Gegenstand mit einem Fremdstoffanteil vorhanden ist. Anschließend springt das Verfahren zu 1003 zurück. Wenn in 1005 ausgewertet wurde, dass kein Gegenstand mit einem Fremdstoffanteil vorhanden ist, springt das Verfahren zu 1003 zurück.

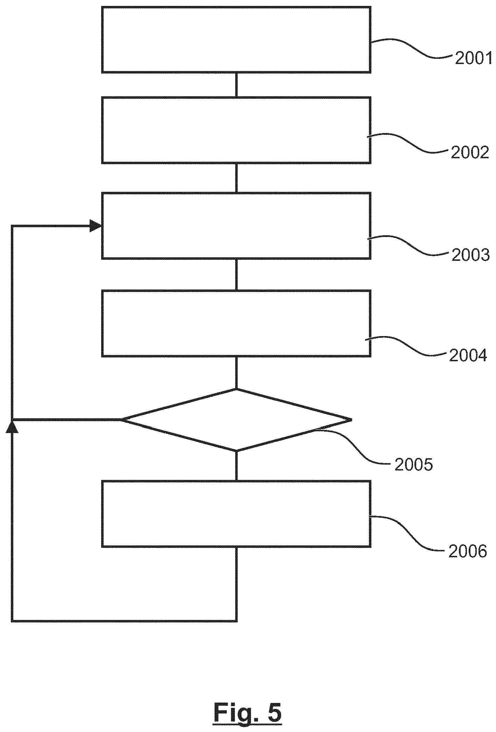

Fig. 5 zeigt ein Ablaufdiagramm eines weiteren Verfahrens, das eine hierin beschriebene Sensorvorrichtung verwendet, gemäß einer Ausführungsform der Offenbarung.

In 2001 wird zunächst ein Detektionsbereich 15 für einen Gegenstand 1 mit einem Fremdstoffanteil, beispielsweise mit einem metallischen Anteil, bereitgestellt. In 2002 wird die Oszillatorschaltung 10 der Sensorvorrichtung in einen Sensorbetrieb versetzt, beispielsweise, indem die Versorgungsspannung VDD eingeschaltet wird.

In 2003 wird dann eine Betriebsgröße ermittelt, die eine Wertveränderung einer zeitlichen Folge von Messwerten einer Stromaufnahme der Oszillatorschaltung 10 während des Detektionszeitraums ist, beispielsweise eine Wertfolge des Betriebsstroms über dem Lastwiderstand RL.

In 2004 wird die ermittelte Betriebsgröße mit einem Referenzwert für die Betriebsgröße verglichen.

In 2005 wird anhand des Vergleichsergebnisses ausgewertet, ob sich ein Gegenstand 1 mit einem Fremdstoffanteil im Detektionsbereich 15 bewegt hat. Wenn sich ein Gegenstand mit einem Fremdstoffanteil im Detektionsbereich 15 bewegt hat, fährt das Verfahren mit 2006 fort. In 2006 wird ausgegeben, dass sich ein Gegenstand mit einem Fremdstoffanteil im Detektionsbereich 15 bewegt hat. Anschließend springt das Verfahren zu 2003 zurück. Wenn in 2005 ausgewertet wurde, dass sich kein Gegenstand mit einem Fremdstoffanteil im Detektionsbereich 15 bewegt hat, springt das Verfahren zu 2003 zurück.

Es versteht sich, dass die hierin beschriebenen Aspekte oder Merkmale miteinander kombinierbar sind und/oder dass einzelne Aspekte oder Merkmale weggelassen oder abgeändert werden können, wenn angemessen. Angemessene Änderungen oder Auslassungen im Rahmen des Umfangs der Patentansprüche sind für den Fachmann erkennbar.

## Patentansprüche

1. Sensorvorrichtung zum Detektieren eines Gegenstandes (1) mit einem Fremdstoffanteil, die Folgendes umfasst:
eine Oszillatorschaltung (10) mit einem Sensorelement (L), das einen Detektionsbereich (15) für den Gegenstand (1) mit dem Fremdstoffanteil definiert, wobei die Oszillatorschaltung einen einzigen Schwingkreis aufweist;
eine Betriebsgrößen-Ermittlungseinrichtung (20), die dazu konfiguriert ist, eine Betriebsgröße zu ermitteln, die mit einer Stromaufnahme der Oszillatorschaltung (10) während eines Sensorbetriebs der Oszillatorschaltung (10) zusammenhängt;
eine Auswertungseinrichtung (40), die dazu konfiguriert ist, unter Verwendung der mit der Betriebsgrößen-Ermittlungseinrichtung (20) ermittelten Betriebsgröße auszuwerten, ob der Gegenstand (1) mit dem Fremdstoffanteil in dem Detektionsbereich (15) vorhanden ist.

2. Sensorvorrichtung nach Anspruch 1,
wobei der Fremdstoffanteil entweder ein Material aus der Gruppe umfasst, die aus einem Metall, Graphit und Ferrit besteht, oder ein dielektrisch verlustbehaftetes Material umfasst.

3. Sensorvorrichtung nach Anspruch 1 oder 2,
wobei die Auswertungseinrichtung (40) eine Vergleichseinrichtung (30) aufweist, die dazu konfiguriert ist, die mit der Betriebsgrößen-Ermittlungseinrichtung (20) detektierte Betriebsgröße mit einem Referenzwert für die Betriebsgröße zu vergleichen.

4. Sensorvorrichtung nacheinem der vorhergehenden Ansprüche,
wobei die Betriebsgröße eine Wertveränderung der Stromaufnahme in einer zeitlichen Folge von Messwerten der Stromaufnahme der Oszillatorschaltung (10) ist.

5. Sensorvorrichtung nach einem der vorhergehenden Ansprüche,
wobei die Oszillatorschaltung (10) als Push-pull-Oszillator ausgebildet ist.

6. Sensorvorrichtung nach einem der vorhergehenden Ansprüche,
wobei die Oszillatorschaltung (10) zwei in Reihe geschaltete Transistoren (Q_1, Q_2) aufweist.

7. Sensorvorrichtung nach einem der vorhergehenden Ansprüche,
wobei die Auswertungseinrichtung (40) dazu konfiguriert ist, die Betriebsgröße fortlaufend in einem zeitlichen Abstand von weniger als 5 µs, optional weniger als 2 µs oder weniger als 1 µs auszuwerten.

8. Sensorvorrichtung nach einem der vorhergehenden Ansprüche,
wobei das Sensorelement (L) eine Spule oder eine Reihenschaltung von Spulen (L1, L2) ist.

9. Sensorvorrichtung nach Anspruch 8,
wobei die Spule oder mindestens eine Spule aus der Reihenschaltung von Spulen (L1, L2) eine Luftspule ist, wobei insbesondere der Detektionsbereich (15) innerhalb des Luftraumes der Luftspule bereitgestellt ist..

10. Sensorvorrichtung nacheinem der vorhergehenden Ansprüche,
wobei das Sensorelement (L) ein Plattenkondensator ist.

11. Sensorvorrichtung nach einem der vorhergehenden Ansprüche,
wobei die Oszillatorschaltung (10) einen Leerlauf-Gütefaktor von mindestens Q=70 oder mindestens Q=80 hat.

12. Verfahren zum Detektieren des Vorhandenseins eines Gegenstandes mit einem Fremdstoffanteil mittels einer Sensorvorrichtung nach einem der Ansprüche 1 bis 11, wobei das Verfahren umfasst:
Bereitstellen (1001) eines Detektionsbereichs (15) für einen Gegenstand (1) mit einem Fremdstoffanteil, wobei der Fremdstoffanteil entweder ein Material aus der Gruppe umfasst, die aus einem Metall, Graphit und Ferrit besteht, oder ein dielektrisch verlustbehaftetes Material umfasst;
Betreiben (1002) der Oszillatorschaltung (10) der Sensorvorrichtung in einem Sensorbetrieb;
Ermitteln (1003) einer Betriebsgröße, die mit einer Stromaufnahme der Oszillatorschaltung (10) während des Sensorbetriebs zusammenhängt;
Vergleichen (1004) der ermittelten Betriebsgröße mit einem Referenzwert für die Betriebsgröße, und Auswerten (1005), anhand des Vergleichsergebnisses, ob ein Gegenstand (1) mit einem Fremdstoffanteil im Detektionsbereich (15) vorhanden ist.

13. Verfahren zum Detektieren der Bewegung eines Gegenstandes mit einem Fremdstoffanteil mittels einer Sensorvorrichtung nach einem der Ansprüche 1 bis 11, wobei das Verfahren umfasst:
Bereitstellen (2001) eines Detektionsbereichs (15) für einen sich relativ zum Sensorelement der Oszillatorschaltung (10) bewegenden Gegenstand (1) mit einem Fremdstoffanteil;
Betreiben (2002) der Oszillatorschaltung (10) der Sensorvorrichtung in einem Sensorbetrieb;
Ermitteln (2003) einer Betriebsgröße, die eine Wertveränderung einer zeitlichen Folge von Messwerten einer Stromaufnahme der Oszillatorschaltung (10) in einem Detektionszeitraum während des Sensorbetriebs ist;
Vergleichen (2004) der ermittelten Betriebsgröße mit einem Referenzwert für die Betriebsgröße, und Auswerten (2005), anhand des Vergleichsergebnisses, ob sich im Detektionszeitraum ein Gegenstand (1) mit einem Fremdstoffanteil im Detektionsbereich (15) bewegt hat.

14. Verfahren nach Anspruch 12 oder 13, wobei das Verfahren ferner umfasst:
Beziehen der ermittelten Betriebsgröße auf einen zeitlichen Abstand aufeinanderfolgender Messwerte in der Folge von Messwerten, und Bestimmen, anhand des Bezugs, einer Größe und/oder einer Position des metallischen Anteils im bzw. am Gegenstand (1).

15. Verwendung einer Sensorvorrichtung nach einem der Ansprüche 1 bis 11 oder eines Verfahrens nach einem der Ansprüche 12 bis 14 zur Detektion eines Gegenstands (1) mit einem Fremdstoffanteil, insbesondere einem metallischen Anteil oder einem Graphitanteil oder einem Ferritanteil, an einer Verarbeitungs- oder Verpackungsstrecke für Lebensmittel.

16. Verwendung einer Sensorvorrichtung nach einem der Ansprüche 1 bis 11 oder eines Verfahrens nach einem der Ansprüche 12 bis 14 zur Detektion eines Gegenstands (1) mit einem Fremdstoffanteil, insbesondere einem metallischen Anteil oder einem Graphitanteil oder einem Ferritanteil, an einer Verarbeitungs- oder Verpackungsstrecke für Tabakteilprodukte und/oder Tabakprodukte, optional für Zigaretten-Teilprodukte oder Zigarettenprodukte.
